# EUROPÄISCHE PATENTSCHRIFT

(11) **EP 1 681 576 B1**
(45) Veröffentlichungstag und Bekanntmachung des Hinweises auf die Patenterteilung: **08.03.2017**
(21) Anmeldenummer: 06000272.2
(22) Anmeldetag: 07.01.2006
(51) Int. Cl.: G01R 33/38, F25D 19/00

(54) **Kryostatanordnung**
Cryostat configuration
Configuration de cryostat

(30) Priorität: 15.01.2005 DE 102005002011
(43) Veröffentlichungstag der Anmeldung: 19.07.2006
(73) Patentinhaber: Bruker BioSpin AG, 8117 Fällanden (CH)
(72) Erfinder: Mraz, Beat, 8608 Bubikon (CH); Meier, Urs, 8620 Wetzikon (CH); Glémot, Agnès, 8006 Zürich (CH); Vogel, Dietrich, 8400 Winterthur (CH)
(74) Vertreter: Kohler Schmid Möbus Patentanwälte

(56) Entgegenhaltungen:
- EP-A2- 0 937 995
- GB-A- 2 015 716
- US-A- 5 385 010
- US-A- 5 613 367
- US-A- 6 109 042

## Beschreibung

Die Erfindung betrifft eine Kryostatanordnung mit einem Außenmantel und einem darin eingebauten Kryobehälter für kryogenes Fluid, wobei der Kryobehälter an mindestens zwei Aufhängerohren mit dem Außenmantel verbunden ist, wobei ein Halsrohr vorgesehen ist, dessen oberes, warmes Ende mit dem Außenmantel und dessen unteres, kaltes Ende mit dem Kryobehälter verbunden ist und in das ein Kaltkopf eines mehrstufigen Kryokühlers eingebaut ist, wobei der Außenmantel, der Kryobehälter, die Aufhängerohre und das Halsrohr einen evakuierten Raum begrenzen, und wobei der Kryobehälter ferner von mindestens einem Strahlungschild umgeben ist, welcher mit den Aufhängerohren und gegebenenfalls auch mit dem Halsrohr des Kryobehälters thermisch leitend verbunden ist.

Eine derartige Kryostatanordnung ist beispielsweise aus US 2002/0002830 bekannt.

Bei Kryostatanordnungen, wie sie zum Beispiel bei Messeinrichtungen zur Kernspinresonanz (NMR) Verwendung finden, ist ein supraleitendes Magnetspulensystem in einem ersten Behälter mit kryogener Flüssigkeit, gewöhnlicherweise flüssigem Helium, angeordnet, welcher von Strahlungsschilden, Superisolationsfolien und gegebenenfalls einem weiteren Behälter mit kryogener Flüssigkeit, gewöhnlicherweise flüssigem Stickstoff, umgeben ist. Die Flüssigkeitsbehälter, Strahlungsschilde und Superisolationsfolien sind in einem äußeren Behälter untergebracht, welcher einen Vakuumraum begrenzt. Der supraleitende Magnet wird durch das verdampfende, ihn umgebende Helium auf einer konstanten Temperatur gehalten. Die den Heliumbehälter umgebenden Elemente dienen der Wärmeisolierung des Behälters, so dass der Wärmeeinfall auf den Behälter minimiert wird und die Abdampfrate des Heliums klein bleibt.

Magnetsysteme zur hochauflösenden NMR-Spektroskopie sind in der Regel so genannte Vertikalsysteme, bei denen die Achse der Spulenanordnung und die Öffnung zur Aufnahme der NMR-Probe in vertikaler Richtung verlaufen. Der Heliumbehälter ist für NMR-Spektrometer gewöhnlicherweise an mindestens zwei dünnwandigen Aufhängerohren mit der äußeren Vakuumhülle verbunden. Zum einen wird der Behälter somit mechanisch fixiert, zum anderen bieten die Aufhängerohre Zugang zum Magneten, wie es z. B. beim Laden notwendig ist. Zudem wird das Verlustgas über die Aufhängerohre abgeführt, wodurch die Aufhängerohre wiederum gekühlt werden und im Idealfall der Wärmeeintrag über die Rohrwand komplett kompensiert wird. Ein derartiges System wird beispielsweise in DE 29 06 060 A1 und in der Druckschrift ,Superconducting NMR Magnet Design' (Concepts in Magnetic Resonance, 1993, 6, 255-273) beschrieben.

Neuerdings werden jedoch auch vermehrt mechanische Kühlapparate, so genannte Kryokühler, zur direkten Kühlung von supraleitenden Magnetsystemen eingesetzt. Neben der Kühlung ohne kryogene Fluide, der so genannten trockenen Kühlung, sind Systeme bekannt, bei denen mindestens ein weiteres kryogenes Fluid vorhanden ist, welches jedoch nach dem Verdampfen vom Kryokühler wieder verflüssigt wird. Dadurch treten nach außen keine oder nahezu keine Verluste an kryogenen Fluiden auf. Möglichkeiten einer derartigen kryogenverlustfreien Kühlung eines supraleitenden Magnetsystems mit einem Kryokühler werden zum Beispiel in den Druckschriften EP 0 905 436, EP 0 905 524, WO 03/036207. WO 03/036190,

US 5 966 944, US 5 563 566, US 5 613 367, US 5 782 095, US 2002/0002830, und US 2003/ 230089 beschrieben. Das Dokument US 5 385 010 offenbart einer Kryokühler mit Temperaturschalter.

Der beispielsweise zweistufige Kaltkopf des Kryokühlers kann in einem separaten Vakuumraum (wie z.B. in US 5 613 367 beschrieben) oder direkt in den Vakuumraum des Kryostaten (wie z.B. in US 5 563 566 beschreiben) so eingebaut werden, dass die erste Kältestufe des Kaltkopfs fest mit einem Strahlungsschild und die zweite Kältestufe über eine feste Wärmebrücke oder direkt mit dem Heliumbehälter thermisch leitend verbunden werden. Durch Rückkondensation des durch Wärmeeinfall von außen verdampfenden Heliums an der kalten Kontaktfläche im Heliumbehälter kann der gesamte Wärmeeinfall auf den Heliumbehälter kompensiert und ein verlustfreier Betrieb des Systems ermöglicht werden. Ein Nachteil hierbei ist, dass die Verbindung von der zweiten Kältestufe zum Heliumbehälter einen thermischen Widerstand aufweist.

Eine Möglichkeit zur Vermeidung dieses thermischen Widerstandes ist das Einfügen des Kaltkopfes in ein Halsrohr, welches die äußere Vakuumhülle des Kryostaten mit dem Heliumbehälter verbindet und entsprechend mit Heliumgas gefüllt ist, wie es beispielsweise in der Druckschrift US 2002/0002830 beschrieben wird. Die erste Kältestufe des zweistufigen Kattkopfes ist wiederum fest leitend mit einem Strahlungsschild kontaktiert, die zweite Kältestufe hängt frei in der Helium-Atmosphäre und verflüssigt direkt das verdampfte Helium.

Bei einer supraleitenden Magnetspule kann es vorkommen, dass - beispielsweise wegen einer kleinen Verschiebung eines Drahtes im Spulenpaket - diese dort resistiv wird, also einen messbaren elektrischen Widerstand aufweist, und der gesamte Magnet quencht. Beim Quench wird die im Magneten gespeicherte magnetische Energie in Wärme umgewandelt und schlagartig freigesetzt. Bei einem mit flüssigem Helium gekühlten Magneten führt dies dazu, dass ein beträchtlicher oder der ganze Teil der Flüssigkeit verdampft und aus dem ersten Tank abgeführt werden muss, damit kein unzulässig hoher Druck entsteht und der Behälter beschädigt wird. Das Quenchgas entweicht in einem konventionellen Kryostaten durch die Aufhängrohre des Heliumbehälters und durch spezielle Sicherheitsventile, so genannte Quenchventile, die bei Erreichen des Quenchdrucks einen großen Öffnungsquerschnitt freigeben.

Ein Quench und das damit verbundenen schlagartige Austreten des Quenchgases stellen insbesondere dann ein Problem dar, wenn aufgrund eines technischen Defekts der Kühler eines kryogenverlustfreien Magnetsystems ausgewechselt werden muss. Bei einem System, bei dem der Kühler in einem Halsrohr eingebaut ist, welches die äußere Vakuumhülle mit dem Heliumbehälter direkt verbindet, besteht die Gefahr, dass bei geladenem Magneten dieser während des Ausbaus quencht und somit der Monteur durch kalte Gase (im Bereich von etwa 5 K bis 100 K) oder den Quenchdruck verletzt wird. Aus diesem Grund muss der Magnet vor einer Demontage des Kryokühlers zunächst entladen werden. Nach dem erneuten Laden des Magneten ist jedoch in der Regel das Magnetfeld über eine gewisse Zeit noch nicht so stabil, dass MR-Spektren aufgenommen werden können. Gerade bei großen Magnetsystemen führt dies dazu, dass das Magnetsystem über einige Tage nicht betrieben werden kann ("Downtime").

Ziel der vorliegenden Erfindung ist es daher, eine Kryostatanordnung vorzuschlagen, bei der ein sicherer Aus- oder Einbau des Kaltkopfes ermöglicht wird, ohne den Betrieb des in der Kryostatanordnung befindlichen Systems, beispielsweise eines Magnetsystems, zu unterbrechen.

Diese Aufgabe wird erfindungsgemäß dadurch gelöst, dass ein manuell und/oder automatisch aktivierbarer Verschluss vorgesehen ist, mittels dessen das kalte Ende des Halsrohres vom Kryobehälter derart abgetrennt werden kann, dass ein Fluidstrom zwischen Kryobehälter und Halsrohr minimiert oder ganz unterbrochen wird.

Der erfindungsgemäße Verschluss kann vor oder während des Ein- beziehungsweise Ausbaus des Kaltkopfes aktiviert werden, so dass eventuell austretende Gase nicht mehr über das Halsrohr abgeleitet werden und somit eine sichere Montage beziehungsweise Demontage des Kaltkopfs ermöglicht wird.

Die Vorteile der erfindungsgemäßen Anordnung kommen besonders gut zur Geltung, wenn der Kryobehälter eine supraleitende Magnetanordnung enthält. Bei derartigen Anordnungen besteht die Gefahr eines Quenchs, bei dem sehr große Mengen an kaltem Gas aus dem Kryobehälter entweichen und Verletzungen beim Wartungspersonal verursachen können. Die erfindungsgemäße Anordnung erlaubt ein sicheres und schnelles Auswechseln des Kaltkopfes auch bei geladenem Magneten und kann somit die "Downtime" von Mess-Systemen mit supraleitenden Magneten minirnieren.

Die erfindungsgemäße Kryostatanordnung kann insbesondere eine Anordnung sein, bei der die supraleitende Magnetanordnung Teil einer Apparatur zur Kernspinresonanz, insbesondere Magnetic Resonance Imaging (MRI) oder Magnetresonanzspektroskopie (NMR) ist.

Bei einer derartigen Kryostatanordnung ist vorteilhafterweise an mindestens einem Aufhängerohr ein Sicherheitsventil angebracht, welches sich im Falle eines Magnetquenchs öffnet, so dass das entstehende Gas durch die entsprechenden Aufhängerohre entweichen kann.

Bei einer vorteilhaften Ausführungsform der erfindungsgemäßen Kryostatanordnung umfasst der Verschluss ein am unteren Ende des Halsrohres fest montiertes, aber lösbares Ventilgehäuse und eine daran angebrachte drehbare Ventilplatte, welche mit einer Feder verspannt sind. Da das Ventilgehäuse lösbar am Halsrohr befestigt ist, lässt sich der Verschluss problemlos aus- und einbauen, so dass auch bereits gefertigte Kryostatanordnungen nachgerüstet werden können. Es ist jedoch auch denkbar, dass eine Kryostatanordnung von vornherein mit einem nicht wieder lösbaren Verschluss ausgestattet wird.

Vorteilhafterweise weisen das Ventilgehäuse und die Ventilplatte jeweils Öffnungen auf, die durch Verdrehen der drehbaren Ventilplatte in eine Arbeitsposition zur Deckung gebracht und durch Verdrehen der drehbaren Ventilplatte in eine Ausbauposition vollkommen abgedeckt werden können. In der Arbeitsposition kann somit ein ungehinderter Gasaustausch zwischen dem Halsrohr und dem Kryobehälter stattfinden, während in der Ausbauposition ein solcher Gasaustausch verhindert wird und somit - selbst bei Auftreten eines Quenchs - eine gefahrlose Montage beziehungsweise Demontage des Kaltkopfs möglich ist.

Bei einer speziellen Ausführungsform lässt sich der Kaltkopf des Kryokühlers frei um seine Achse drehen, kann in seiner Arbeitsposition aber fixiert werden. Zur Entnahme des Kaltkopfs kann dieser dann durch einer Drehbewegung in die Ausbauposition gebracht werden.

Dies ist insbesondere vorteilhaft, wenn die drehbare Ventilplatte des Verschlusses mindestens zwei Mitnehmerelemente aufweist. Die Ventilplatte lässt sich dann über diese Elemente verdrehen.

Besonders vorteilhaft ist es, wenn am unteren Ende des Kaltkopfs des Kryokühlers ein Betätigungselement angebracht ist, welches in die Mitnehmerelemente an der drehbaren Ventilplatte des Verschlusses greift. Die Position der Ventilplatte kann somit über eine Drehung des Kaltkopfes verändert und der Verschluss geöffnet beziehungsweise verschlossen werden.

Eine vorteilhafte Ausführungsform der Erfindung sieht vor, dass zum Öffnen des Verschlusses zwischen Halsrohr und Kryobehälter der Kaltkopf des Kryokühlers bis zu einem ersten Anschlag verdreht werden kann.

Bei einer Weiterbildung dieser Ausführungsform kann nach Verdrehen des Kaltkopfs des Kryokühlers bis zum ersten Anschlag dieser um einen definierten Winkel in seine Arbeitsposition zurückverdreht werden, in der sich Betätigungselement und Mitnehmerelemente nicht mehr berühren. Hierdurch werden eine thermische Verbindung und die Übertragung von Vibrationen zwischen Kaltkopf und Halsrohr vermieden.

Eine weitere Weiterbildung dieser Ausführungsform sieht vor, dass zum Schließen des Verschlusses zwischen Halsrohr und Kryobehälter der Kaltkopf des Kryokühlers bis zu einem, dem ersten Anschlag entgegengesetzten, zweiten Anschlag verdreht werden kann. Durch die Drehbewegung des Kaltkopfes in Richtung des zweiten Anschlags wird die Ventilplatte derart gegenüber dem Ventilgehäuse verdreht, dass die Öffnungen nicht mehr in Deckung sind und daher ein Gassaustausch zwischen dem Kryobehälter und dem Haisrohr der Kryostatanordnung verhindert wird.

Des Weiteren ist es vorteilhaft, wenn nach dem Verdrehen des Kaltkopfs des Kryokühlers bis zum zweiten Anschlag dieser um einen definierten Winkel zurückverdreht werden kann, in der sich das Betätigungselement in einer Mittelstellung zwischen den Mitnehmerelementen befindet. Das Betätigungselement und die Mitnehmerelemente berühren sich dann nicht mehr, wodurch ein problemloser Ausbau des Kaltkopfes gewährleistet wird.

Bei einer besonders vorteilhaften Weiterbildung dieser Ausführungsform kann der Kaltkopf des Kryokühlers ausschließlich in der um den definierten Winkel zurückverdrehten Position (Ausbauposition) aus dem Halsrohr entnommen werden und ist in allen anderen Positionen verriegelt. Somit wird einerseits sichergestellt, dass der Kühler nur in einer definierten (und gefahrlosen) Position aus- und eingebaut werden kann. Andererseits wird der Aus- und Einbau auf Grund von Maßabweichungen durch Toleranzen bei der Herstellung der Bauteile nicht erschwert.
Eine alternative Ausführungsform der erfindungsgemäßen Kryostatanordnung sieht vor, dass unterhalb eines Aufhängerohres des Kryobehälters in Verlängerung der Achse des Aufhängerohres im Kryobehälter ein Drehelement angeordnet ist, welches über einen Betätigungsstab, der durch das Aufhängerohr bei Bedarf eingeschoben wird, verdreht werden kann. Die Betätigung der Ventilplatte erfolgt hier nicht durch das Halsrohr sondern durch eines der Aufhängerohre. Dies ist insbesondere vorteilhaft, wenn der Kaltkopf des Kühlers nicht auf Torsion beansprucht werden soll oder bei engen Platzverhältnissen nicht gedreht werden kann. Bei einer Weiterbildung dieser Ausführungsform ist die Ventilplatte über einen Seilzug mit dem Drehelement unterhalb des Aufhängerohres verbunden.

Alternativ dazu kann es vorteilhaft sein, wenn die Ventilplatte über eine Kette mit dem Drehelement unterhalb des Aufhängerohres verbunden ist.

Eine weitere mögliche Weiterbildung besteht darin, dass die Ventilplatte über eine Zug- und eine Druckstange oder eine einzige Zug-/ Druckstange mit dem Drehelement unterhalb des Aufhängerohres verbunden ist.

Bei einer weiteren alternativen Ausführungsform umfasst der Verschluss eine am unteren Ende des Halsrohres fest montierte Gegenplatte mit einer Öffnung und einem Ventilkegel sowie eine Ventilplatte. Die Ventilplatte ist über einen mit der Gegenplatte verbundenen Wellbalg in der Achse des Halsrohres beweglich und weist einen Öffnungsquerschnitt auf, der wesentlich kleiner ist als die Querschnittsfläche der Aufhängerohre und Sicherheitsventile des Kryobehälters. Bei erhöhtem Druck im Kryobehälter wird die Ventilplatte mit ihrer Öffnung gegen den Ventilkegel gedrückt und trennt somit das Gasvolumen des Halsrohrs von dem des Kryobehälters. Vorteilhaft bei dieser Ausführungsform ist insbesondere die Tatsache, dass der Verschluss nicht manuell betätigt werden muss, sondern im Falle eines Quenchs selbst schließt.

Bei einer Weiterbildung dieser Ausführungsform ist der Ventilkegel horizontal fixiert und in vertikaler Richtung mit einer Feder vorgespannt und beweglich. Der Aufprall der Ventilplatte auf den Ventilkegel im Quenchfall wird dadurch gedämpft. Zudem wird die Anpresskraft der Ventilteile durch die Federkraft dadurch definiert.

Des Weiteren ist es vorteilhaft, wenn der Hub der Ventilplatte in Richtung der Achse des Halsrohres durch mindestens ein Anschlagelement begrenzt ist. Hierdurch wird vermieden, dass der Wellbalg zu stark komprimiert wird.

Bei einer weiteren Ausführungsform der erfindungsgemäßen Kryostatanordnung besteht der Verschluss aus einer einzigen fest montierten, aber lösbaren Platte, die mit einer Öffnung von vorgegebenem Querschnitt versehen ist. Es ist jedoch auch denkbar, dass die Platte nicht wieder lösbar mit dem Halsrohr oder Kryobehälter verbunden ist.

Vorteilhafterweise ist der Querschnitt der Öffnung wesentlich kleiner als die Querschnittsfläche der Aufhängerohre und Sicherheitsventile des Kryobehälters. Dadurch wird gewährleistet, dass im Falle eines Quenchs nur ein kleiner Teil des Quenchgases durch das Halsrohr entweicht.

Eine Weiterbildung dieser Ausführungsform ist so gestaltet, dass die Öffnung in der Platte so angebracht ist, dass der Gasstrom im Falle eines Quenchs in Halsrohrrichtung in das Halsrohr eintritt. Dies lässt sich besonders einfach realisieren.

Eine besonders vorteilhafte, alternative Weiterbildung dagegen sieht vor, dass die Öffnung in der Platte derart gestaltet ist dass der Gasstrom im Falle eines Quenchs quer zur Halsrohrrichtung in das Halsrohr eintritt. Das austretende Gas kann somit über den gesamten Querschnitt des Halsrohrs aus diesem abströmen.

Darüber hinaus kann bei der erfindungsgemäßen Kryostatanordnung ein manuell aktivierbarer Verschluss mit einem automatisch aktivierbaren Verschluss beliebig kombinierbar sein.

Vorzugsweise ist das im Kryobehälter befindliche kryogene Fluid flüssiges Helium. Es ist jedoch vorstellbar, dass bei zukünftigen Magnetsystemen auch andere kryogene Fluide als Helium zur Kühlung zum Einsatz kommen, z.B. flüssiges Neon oder flüssiger Stickstoff. Die Normalsiedetemperaturen dieser Stoffe sind höher als bei Helium, aber ausreichend tief, wenn zum Beispiel Hochtemperatursupraleiter als Drähte für die Magnete eingesetzt werden. Im Falle eines Magnetquenchs würde somit kaltes Neon oder kalter Stickstoff freigesetzt werden.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

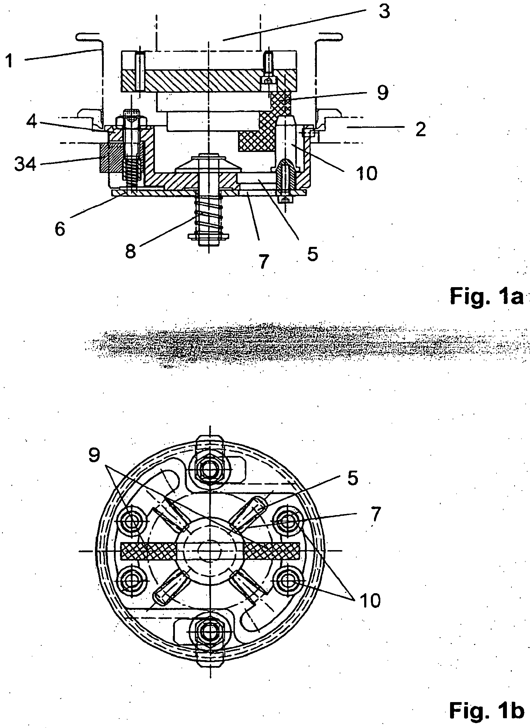

- Fig. 1a: eine schematische Seitenansicht eines in ein Halsrohr einer erfindungsgemäßen Kryostatanordnung eingebauten Verschlusses mit einer drehbaren Ventilplatte;
- Fig. 1 b: eine schematische Aufsicht des Verschlusses aus Fig. 1a;
- Fig. 2a: eine schematische Aufsicht des Halsrohrs und des Verschlusses einer ersten Ausführungsform der erfindungsgemäßen Kryostatanordnung, wobei sich ein Mitnehmer- und das Betätigungselement am ersten Anschlag befinden (Ventil offen);
- Fig. 2b: eine schematische Aufsicht des Halsrohrs und des Verschlusses einer ersten Ausführungsform der erfindungsgemäßen Kryostatanordnung, wobei sich die Mitnehmerelemente und das Betätigungselement in der Arbeitsposition befinden (Ventil offen, vibrationsentkoppelt);
- Fig. 2c: eine schematische Aufsicht des Halsrohrs und des Verschlusses einer ersten Ausführungsform der erfindungsgemäßen Kryostatanordnung, wobei sich die Mitnehmerelemente und das Betätigungselement in der Ausbauposition befinden (Ventil geschlossen);
- Fig. 3: eine schematische Schnittdarstellung des Halsrohrs und eines Aufhängerohrs, sowie des Verschlusses einer zweiten Ausführungsform der erfindungsgemäßen Kryostatanordnung mit einem Betätigungsmechanismus im Aufhängerohr des Kryobehälters;
- Fig. 4: eine schematische Schnittdarstellung eines selbstschließenden Verschlusses;
- Fig. 5: eine schematische Schnittdarstellung eines in einem Halsrohr einer Kryostatanordnung fix eingebauten Verschlusses mit definierter Öffnung; und
- Fig. 6: eine schematische Darstellung einer weiteren Ausführungsform der erfindungsgemäßen Anordnung mit einer Kombination eines manuell und eines automatisch aktivierten Verschlusses.

**Fig. 1** **a** zeigt einen Ausschnitt einer Kryostatanordnung mit einem in einem Halsrohr **1** eines Kryobehälters **2** angeordneten Kaltkopf **3** eines Kryokühlers. Am kalten, unteren Ende des Halsrohres 1 ist ein metallisches Ventilgehäuse **4** fest montiert, welches Öffnungen **5,** z.B. in Form von Bohrungen oder Schlitzen aufweist, wie in **Fig. 1b** dargestellt. Unter dem Ventilgehäuse 4 befindet sich eine bewegliche metallische Ventilplatte **6,** die annähernd deckungsgleiche Öffnungen **7** wie das Ventilgehäuse 4 besitzt. Die Ventilplatte 6 wird, wie in Fig. 1a gezeigt, mit einer Feder **8** auf das Ventilgehäuse 4 gepresst, wobei sich kein weiteres Dichtmaterial zwischen Ventilplatte 6 und Ventilgehäuse 4 befindet. Durch Verdrehen der Ventilplatte 6 ist es möglich, die Öffnungen 7 der Ventilplatte 6 mit den Öffnungen 5 des Ventilgehäuses 4 in Deckung zu bringen, so dass zwischen Halsrohr 1 und Kryobehälter 2 ungehindert ein Gasaustausch stattfinden kann. Umgekehrt können die Öffnungen 5, 7 durch Verdrehen der Ventilplatte 6 verschlossen werden. In diesem Fall ist kein Gasaustausch zwischen Kryobehälter 2 und Halsrohr 1 mehr möglich, sieht man von den minimalen Leckagen durch den engen Spalt zwischen Ventilplatte 6 und Ventilgehäuse 4 ab. Das Ventilgehäuse 4 kann mit speziellen Verriegelungselementen **34** an der Halsrohröffnung im Kryobehälter 2 befestigt werden und ist mit diesem somit wieder lösbar und nicht fest (geschweißt oder gelötet) verbunden. Somit lässt sich der gesamte Verschluss einfach aus-und einbauen und gegebenenfalls können bestehende Kryostatanordnungen noch nachgerüstet werden.

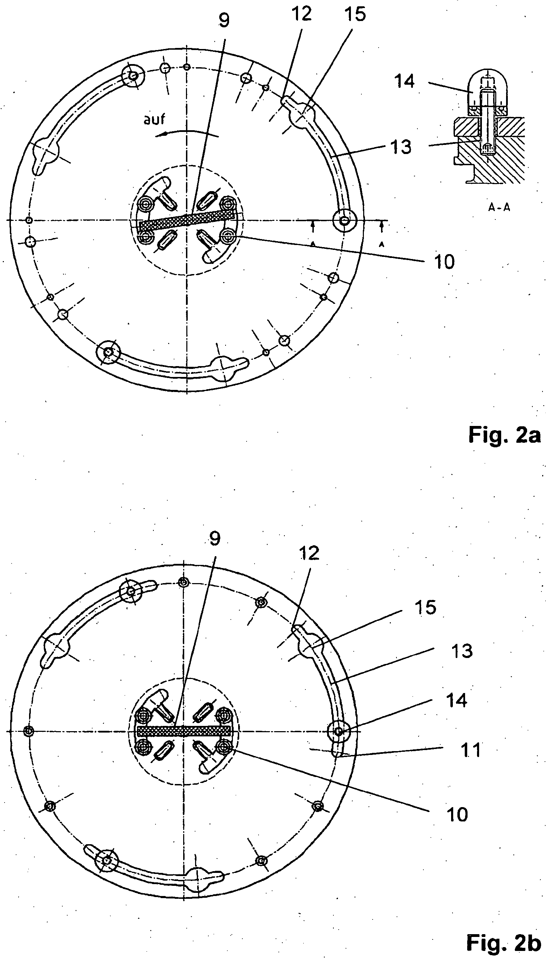

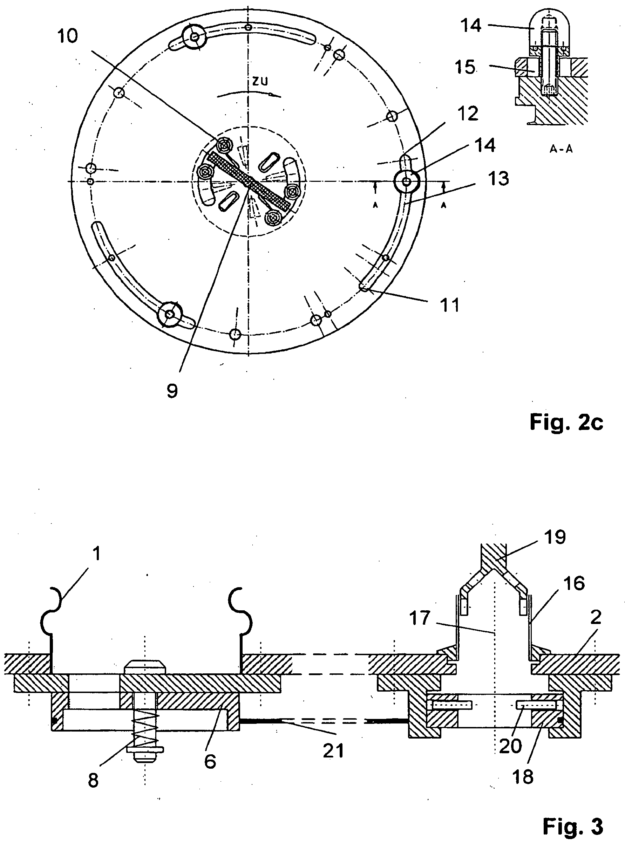

Der Kaltkopf 3 des Kryokühlers, der sich im Halsrohr 1 befindet, kann - nach Lösen einer Verriegelung - frei im Halsrohr 1 gedreht werden, wobei er vertikal noch geführt ist. Am unteren, kalten Ende des Kaltkopfes 3 ist ein Betätigungselement **9** angebracht, welches in ein Mitnehmerelement **10** auf der Ventilplatte 6 greift, so dass die Position der Ventilplatte 6 über eine Drehung des Kaltkopfes 3 verändert werden kann. **Fig. 2a****-c** zeigen die Mitnehmerelemente 10 und das Betätigungselement 9 in verschiedenen Positionen. Der Verschluss wird ganz geöffnet, wenn der Kaltkopf 3 bis zu einem ersten **Anschlag 11** verdreht wird (Fig. 2a). Anschließend muss der Kaltkopf 3 noch einen kleinen vorgegebenen Winkel zurückgedreht werden, so dass sich Betätigungselement 9 und Mitnehmerelemente 10 nicht mehr berühren. Dadurch wird vermieden, dass einerseits eine thermische Brücke zwischen Kaltkopf 3 und Halsrohr 1 besteht, und dass andererseits Störungen und Vibrationen vom Kaltkopf 3 auf das Halsrohr 1 und indirekt auch auf den Kryobehälter 2 übertragen werden. Der Kaltkopf 3 befindet sich dann in seiner Arbeitsposition (Fig. 2b). Soll nun das Gasvolumen des Halsrohrs 1 von dem des Kryobehälters 2 getrennt werden, so wird der Kaltkopf 3 in die andere Richtung zum zweiten Anschlag **12** gedreht. Anschließend wird der Kaltkopf 3 wiederum einen kleinen Winkel zurück in die Ausbau- bzw. Einbauposition gedreht (Fig. 2c). Das Betätigungselement befindet sich dann in einer Mittelstellung zwischen den Mitnehmerelementen, wobei diese Mittelstellung nicht exakt in der Mitte zwischen den Mitnehmerelementen lokalisiert sein muss. Es soll lediglich gewährleistet sein, dass Maßabweichungen durch Toleranzen bei der Herstellung der Bauteile vor allem den Einbau nicht erschweren und sich das Betätigungselement 9 und die Mitnehmerelemente 10 nicht berühren. In der Aus- bzw. Einbauposition ist der Kaltkopf 3 nicht mehr verriegelt und kann gefahrlos aus dem Halsrohr 1 entnommen werden. Die Verriegelung beziehungsweise Entriegelung des Kaltkopfes 3 kann beispielsweise durch einen oder mehrere am oberen Einbauflansch des Kaltkopfs 3 angebrachte, in Umfangsrichtung verlaufende Führungsspalte **13** realisiert sein, in denen ein im Bereich der Schiene verjüngtes Anschlagselement **14** geführt wird, wobei die Führungsspalte an der Stelle, an der sich das Anschlagselement in der Ausbauposition des Kaltkopfs 3 befindet, eine Öffnung **15** aufweisen, durch die hindurch das Anschlagselement 14 geführt werden kann, um den Kaltkopf 3 zu entnehmen. Tritt gerade im Moment des Ausbaus des Kaltkopfs 3 ein Quench auf, so muss dann allenfalls mit einem sehr kleinen Quenchgasstrom durch die engen Spalte zwischen Ventilplatte 6 und Ventilgehäuse 4 gerechnet werden, der keine Gefahr für den Monteur darstellt. Die beschriebene Anordnung ist unter dem Gesichtspunkt der Sicherheit besonders vorteilhaft, da der Kaltkopf 3 des Kryokühlers nur dann ausgebaut werden kann, wenn der Verschluss wirklich geschlossen ist.

Alternativ dazu lässt sich die Ventilplatte 6 auch über einen Mechanismus im Aufhängerohr **16** des Kryobehälters 2 betätigen **(****Fig. 3****).** Zu diesem Zwecke wird unterhalb eines Aufhängerohrs 16 in Verlängerung der Achse 17 des Aufhängerohrs 16 ein scheibenförmiges Drehelement **18** angebracht. Dieses kann über einen speziellen Betätigungsstab **19** betätigt werden, der in das Aufhängerohr 16 eingeführt wird und in am Drehelement 18 angebrachte Stifte **20** eingreift. Nach der Manipulation kann der Betätigungsstab 19 wieder aus dem Aufhängerohr 16 entnommen werden kann: Das Drehelement 18 ist entweder über einen Seilzug **21** oder eine Kette oder zwei Stäbe (ein Zug- und ein Druckstab) oder nur einen Stab (der einmal auf Zug und ein andermal auf Druck beansprucht wird) mit der Ventilplatte 6 verbunden, die unterhalb des Halsrohrs 1 angeordnet ist. Die Fixierung des Seilzugs 21 an dem Drehelement 18 und der Ventilplatte 6 kann beispielsweise über eine Klemmverbindung erfolgen, so dass die Drehbewegung des Betätigungsstabes 19 vom Drehelement 18 auf die Ventilplatte 6 übertragen wird. Um sicherzustellen, dass der Verschluss ganz offen beziehungsweise ganz geschlossen ist, kann das Drehelement 18 oder auch die Ventilplatte mit entsprechenden Anschlägen ausgestattet sein. Diese Methode zur Betätigung der Ventilplatte 6 empfiehlt sich vor allem dann, wenn der Kaltkopf 3 des Kryokühlers als Betätigüngselement eher ungeeignet ist, da er nicht auf Torsion beansprucht werden soll oder bei engen Platzverhältnissen der Kaltkopf nicht gedreht werden kann.

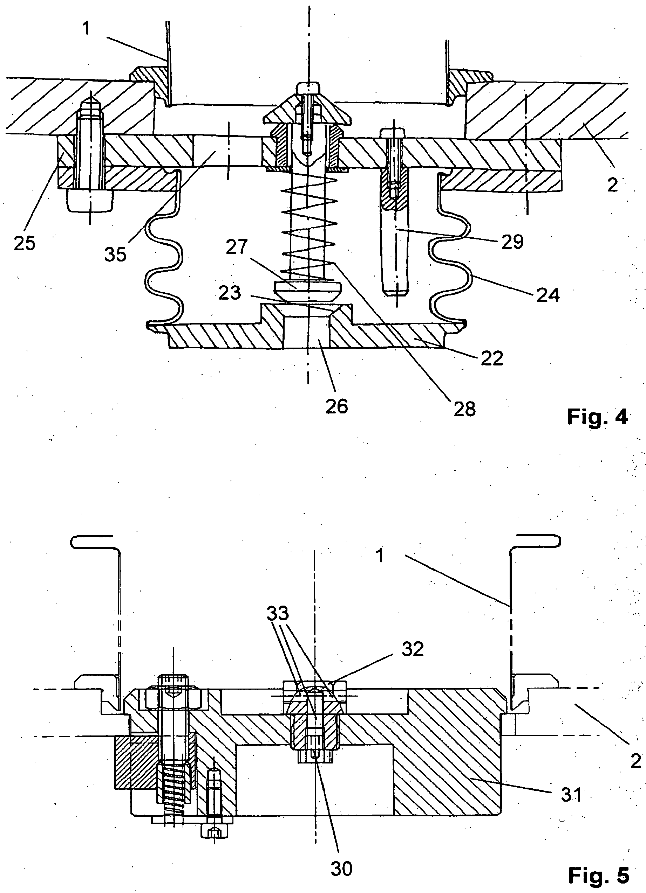

Eine weitere Ausführungsform der erfindungsgemäßen Kryostatanordnung sieht einen Verschluss vor, der bei einem Quench von selbst schließt **(****Fig. 4****).** Eine Ventilplatte **22** mit Ventilsitz **23** und Öffnung **26** ist über einen Wellbalg **24** mit einer Gegenplatte **25** verbunden, die am unteren Ende des Halsrohrs 1 montiert ist und eine Öffnung **35** aufweist. Somit ist die Ventilplatte 22 vertikal beweglich, während sie sich in horizontale Richtung nur minimal bewegen kann. Die Öffnung 26 in der Ventilplatte 22 wirkt wie eine Drossel, so dass sich im Fall eines Quenchs ein Druckunterschied über die Ventilplatte 22 ausbildet. Die Ventilplatte 22 bewegt sich dadurch in Richtung eines Ventilkegels **27,** der sich an der Gegenplatte 25 befindet und in vertikaler Richtung nicht fixiert, aber mit einer Feder **28** vorgespannt ist. Wenn Ventilplatte 22 und Ventilkegel 27 aufeinander treffen, wird das Gasvolumen des Halsrohrs 1 von dem des Kryobehälters 2 getrennt. Da der Ventilkegel 27, wie erwähnt, nicht fixiert ist, bewegt sich die Ventilplatte 22 abhängig vom Quenchdruck unter Umständen noch weiter nach oben, bis sie auf drei Anschlagelementen **29** aufsteht. Diese schützen den Wellbalg 24 gegen unzulässige Kompression. Ferner bewirkt die Feder 28, dass die Anpresskraft zwischen Ventilsitz 23 und Ventilkegel 27 definiert ist.

Schließlich erfüllt auch eine Ausführungsform den geforderten Zweck, bei der kein eigentlicher Verschlussmechanismus vorhanden ist **(****Fig. 5****).** Vielmehr wird eine Öffnung **30** in einer den Kryobehälter 2 vom Halsrohr 1 trennenden Platte **31** so klein gewählt, dass im Falle eines Quenchs nur ein kleiner Teil des Quenchgases durch das Halsrohr 1 strömt und der größte Teil über Aufhängerohre des Kryobehälters 2 abgeführt wird. Die Öffnung 30 muss lediglich so groß sein, dass im Normalbetrieb der Dampf des Kryogens aus dem Kryobehälter 2 in das Halsrohr 1 eintreten und am Kaltkopf 3 des Kryokühlers verflüssigt werden kann. Das verflüssigte Kryogen läuft dann im Gegenstrom zum Dampf vom Halsrohr 1 in den Kryobehälter 2 zurück. Mittels einer Strömungsschikane lässt sich zudem vermeiden, dass der im Quenchfall austretende Dampf durch das Halsrohr 1 senkrecht nach oben wegströmt. Vielmehr wird es in Richtung Halsrohrwand geführt, wodurch es sich verwirbelt und nun über den ganzen Querschnitt das Halsrohr 1 verlässt. Dies könnte beispielsweise mittels eines Zapfens **32** realisiert sein, der in die Öffnung 30 der Platte 31 geschraubt wird, und der im unteren Bereich ein Sackloch in Achsenrichtung und im oberen Bereich eine durchgehende Bohrung **33** senkrecht dazu aufweist, wie in Fig. 5 dargestellt.

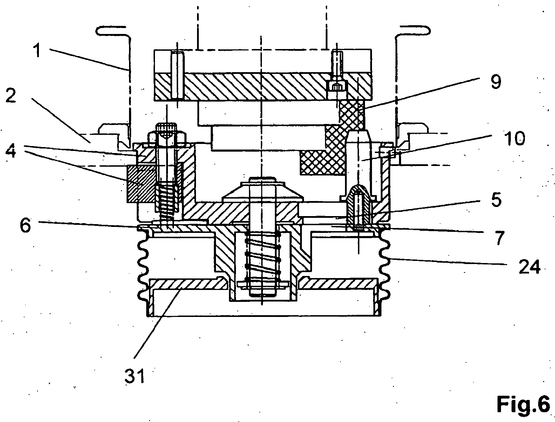

**Fig. 6** zeigt eine Ausführungsform der Erfindung, bei der ein manuell und ein automatisch aktivierbarer Verschluss kombiniert sind. Der automatische Verschluss ist hierbei unterhalb des manuell aktivierbaren Verschlusses angeordnet, so dass eine Betätigung des manuellen Verschlusses durch das Halsrohr realisiert werden kann. Es sind jedoch auch andere Anordnungen beziehungsweise Kombinationsmöglichkeiten der zuvor beschriebenen Ausführungsformen möglich. Durch eine derartige Ausgestaltung kann die Sicherheit des Systems zusätzlich erhöht werden

Sämtliche Ausführungsformen der vorliegenden Erfindung ermöglichen einen gefahrlosen Ein- beziehungsweise Ausbau eines Kaltkopfes in ein Halsrohr eines Kryobehälters.

**Bezugszeichenliste**

| | | | |
|---|---|---|---|
| 1 | Halsrohr | 19 | Betätigungsstab |
| 2 | Kryobehälter | 20 | Stift |
| 3 | Kaltkopf | 21 | Seilzug |
| 4 | Ventilgehäuse | 22 | Ventilplatte |
| 5 | Öffnungen des Ventilgehäuses | 23 | Ventilsitz |
| 6 | drehbare Ventilplatte | 24 | Wellbalg |
| 7 | Öffnungen der Ventilplatte | 25 | Gegenplatte |
| 8 | Feder | 26 | Öffnung der Ventilplatte |
| 9 | Betätigungselement | 27 | Ventilkegel |
| 10 | Mitnehmerelement | 28 | Feder |
| 11 | erster Anschlag | 29 | Anschlagelemente |
| 12 | zweiter Anschlag | 30 | Öffnung der Platte |
| 13 | Führungsspalt | 31 | Platte |
| 14 | Anschlagselement | 32 | Zapfen |
| 15 | Öffnung im Führungsspalt | 33 | Bohrung |
| 16 | Aufhängerohr | 34 | Verriegelungselement |
| 17 | Achse des Aufhängerohrs | 35 | Öffnung der Gegenplatte |
| 18. | Drehelement | | |

## Patentansprüche

1. Kryostatanordnung mit einem Außenmantel und einem darin eingebauten Kryobehälter (2) für kryogenes Fluid,
wobei der Kryobehälter (2) an mindestens zwei Aufhängerohren (16) mit dem Außenmantel verbunden ist,
wobei ein Halsrohr (1) vorgesehen ist, dessen oberes, warmes Ende mit dem Außenmantel und dessen unteres, kaltes Ende mit dem Kryobehälter (2) verbunden ist und in das ein Kaltkopf (3) eines mehrstufigen Kryokühlers eingebaut ist, wobei der Außenmantel, der Kryobehälter (2), die Aufhängerohre (16) und das Halsrohr (1) einen evakuierten Raum begrenzen,
wobei der Kryobehälter (2) ferner von mindestens einem Strahlungsschild umgeben ist, welcher mit den Aufhängerohren (16) und gegebenenfalls auch mit dem Halsrohr (1) des Kryobehälters (2) thermisch leitend verbunden ist,
und wobei ein manuell und/oder automatisch aktivierbarer Verschluss vorgesehen ist, mittels dessen das kalte Ende des Halsrohres (1) vom Kryobehälter (2) derart abgetrennt werden kann, dass ein Fluidstrom zwischen Kryobehälter (2) und Halsrohr (1) minimiert oder ganz unterbrochen wird.

2. Kryostatanordnung nach Anspruch 1, **dadurch gekennzeichnet, dass** der Kryobehälter (2) eine supraleitende Magnetanordnung enthält.

3. Kryostatanordnung nach Anspruch 2, **dadurch gekennzeichnet, dass** die supraleitende Magnetanordnung Teil einer Apparatur zur Kernspinresonanz, insbesondere Magnetic Resonance Imaging (MRI) oder Magnetresonanzspektroskopie (NMR) ist.

4. Kryostatanordnung nach einem der Ansprüche 2 oder 3, **dadurch gekennzeichnet, dass** an mindestens einem Aufhängerohr (16) ein Sicherheitsventil angebracht ist, welches sich im Falle eines Magnetquenchs öffnet.

5. Kryostatanordnung nach einem der vorhergehenden Ansprüchen, **dadurch gekennzeichnet, dass** der Verschluss ein am unteren Ende des Halsrohres (1) fest montiertes, aber lösbares Ventilgehäuse (4) und eine daran angebrachte drehbare Ventilplatte (6) umfasst, welche mit einer Feder (8) verspannt sind.

6. Kryostatanordnung nach Anspruch 5, **dadurch gekennzeichnet, dass** das Ventilgehäuse (4) und die Ventilplatte (6) jeweils Öffnungen (5, 7) aufweisen, die durch Verdrehen der drehbaren Ventilplatte (6) in eine Arbeitsposition zur Deckung gebracht und durch Verdrehen der drehbaren Ventilplatte (6) in eine Ausbauposition vollkommen abgedeckt werden können.

7. Kryostatanordnung nach einem der vorhergehenden Ansprüchen, **dadurch gekennzeichnet, dass** sich der Kaltkopf (3) des Kryokühlers frei um seine Achse drehen lässt, in seiner Arbeitsposition aber fixiert werden kann.

8. Kryostatanordnung nach einem der Ansprüche 5 bis 6 oder nach Anspruch 7 sofern sich dieser auf Anspruch 5 oder 6 bezieht, **dadurch gekennzeichnet, dass** die drehbare Ventilplatte (6) des Verschlusses mindestens zwei Mitnehmerelemente (10) aufweist.

9. Kryostatanordnung nach Anspruch 8, **dadurch gekennzeichnet, dass** am unteren Ende des Kaltkopfs (3) des Kryokühlers ein Betätigungselement (9) angebracht ist, welches in die Mitnehmerelemente (10) an der drehbaren Ventilplatte (6) des Verschlusses greift.

10. Kryostatanordnung nach Anspruch 9, **dadurch gekennzeichnet, dass** zum Öffnen des Verschlusses zwischen Halsrohr (1) und Kryobehälter (2) der Kaltkopf (3) des Kryokühlers bis zu einem ersten Anschlag (11) verdreht werden kann.

11. Kryostatanordnung nach Anspruch 10, **dadurch gekennzeichnet, dass** nach Verdrehen des Kaltkopfs (3) des Kryokühlers bis zum ersten Anschlag (11) dieser um einen definierten Winkel in seine Arbeitsposition zurückverdreht werden kann, in der sich Betätigungselement (9) und Mitnehmerelemente (10) nicht mehr berühren.

12. Kryostatanordnung nach einem der Ansprüche 10 oder 11, **dadurch gekennzeichnet, dass** zum Schließen des Verschlusses zwischen Halsrohr (1) und Kryobehälter (2) der Kaltkopf (3) des Kryokühlers bis zu einem, dem ersten Anschlag (11) entgegengesetzten, zweiten Anschlag (12) verdreht werden kann.

13. Kryostatanordnung nach Anspruch 12, **dadurch gekennzeichnet, dass** nach Verdrehen des Kaltkopfs (3) des Kryokühlers bis zum zweiten Anschlag (12) dieser um einen definierten Winkel zurückverdreht werden kann, in der sich das Betätigungselement (9) in einer Mittelstellung zwischen den Mitnehmerelementen (10) befindet.

14. Kryostatanordnung nach Anspruch 13, **dadurch gekennzeichnet, dass** der Kaltkopf (3) des Kryokühlers ausschließlich in der um den definierten Winkel zurückverdrehten Position (Ausbauposition) aus dem Halsrohr (1) entnommen werden kann und in allen anderen Positionen verriegelt ist.

15. Kryostatanordnung nach einem der Ansprüche 1 bis 4, **dadurch gekennzeichnet, dass** unterhalb eines Aufhängerohres (16) des Kryobehälters (2) in Verlängerung der Achse (17) des Aufhängerohres (16) im Kryobehälter (2) ein Drehelement (18) angeordnet ist, welches über einen Betätigungsstab (19), der durch das Aufhängerohr (16) bei Bedarf eingeschoben wird, verdreht werden kann.

16. Kryostatanordnung nach Anspruch 15 **dadurch gekennzeichnet, dass** eine Ventilplatte (6) über einen Seilzug (21) mit dem Drehelement (18) unterhalb des Aufhängerohres (16) verbunden ist.

17. Kryostatanordnung nach Anspruch 15 **dadurch gekennzeichnet, dass** eine Ventilplatte (6) über eine Kette mit dem Drehelement (18) unterhalb des Aufhängerohres (16) verbunden ist.

18. Kryostatanordnung nach Anspruch 15 **dadurch gekennzeichnet, dass** eine Ventilplatte (6) über eine Zug- und eine Druckstange oder eine einzige Zug-/ Druckstange mit dem Drehelement (18) unterhalb des Aufhängerohres (16) verbunden ist.

19. Kryostatanordnung nach Anspruch 4, **dadurch gekennzeichnet, dass** der Verschluss eine am unteren Ende des Halsrohres (1) fest montierte Gegenplatte (25) mit einer Öffnung (35) und einem Ventilkegel (27) sowie eine über einen mit der Gegenplatte (25) verbundenen Wellbalg (24) in Achse des Halsrohres (1) bewegliche Ventilplatte (22) umfasst, deren Öffnungsquerschnitt wesentlich kleiner ist als die Querschnittsfläche der Aufhängerohre (16) und Sicherheitsventile des Kryobehälters (2).

20. Kryostatanordnung nach Anspruch 19, **dadurch gekennzeichnet, dass** der Ventilkegel (27) horizontal fixiert und in vertikaler Richtung mit einer Feder (28) vorgespannt und beweglich ist.

21. Kryostatanordnung nach einem der Ansprüche 19 oder 20, **dadurch gekennzeichnet, dass** der Hub der Ventilplatte (22) in Richtung der Achse des Halsrohres (1) durch mindestens ein Anschlagelement (29) begrenzt ist.

22. Kryostatanordnung nach einem der Ansprüchen 1 bis 4, **dadurch gekennzeichnet, dass** der Verschluss aus einer einzigen fest montierten, aber lösbaren Platte (31) besteht, die mit einer Öffnung (30) von vorgegebenem Querschnitt versehen ist.

23. Kryostatanordnung nach Anspruch 22, **dadurch gekennzeichnet, dass** der Querschnitt der Öffnung (30) wesentlich kleiner ist als die Querschnittsfläche der Aufhängerohre (16) und Sicherheitsventile des Kryobehälters (2).

24. Kryostatanordnung nach einem der Ansprüche 22 oder 23, **dadurch gekennzeichnet, dass** die Öffnung (30) in der Platte (31) so angebracht ist, dass der Gasstrom im Falle eines Quenchs in Halsrohrrichtung in das Halsrohr (1) eintritt.

25. Kryostatanordnung nach einem der Ansprüche 22 oder 23, **dadurch gekennzeichnet, dass** die Öffnung (30) in der Platte (31) derart gestaltet ist, dass der Gasstrom im Falle eines Quenchs quer zur Halsrohrrichtung in das Halsrohr (1) eintritt.

26. Kryostatanordnung nach einem der vorhergehenden Ansprüchen, **dadurch gekennzeichnet, dass** ein manuell aktivierbarer Verschluss mit einem automatisch aktivierbaren Verschluss beliebig kombinierbar ist.

27. Kryostatanordnung nach einem der vorhergehenden Ansprüchen, **dadurch gekennzeichnet, dass** das im Kryobehälter (2) befindliche kryogene Fluid Helium ist.

## Claims

1. Cryostat configuration comprising an outer shell and a cryocontainer (2) for cryogenic fluid installed therein,
wherein the cryocontainer (2) is connected to the outer shell via at least two suspension tubes (16),
wherein a neck tube (1) is provided whose upper warm end is connected to the outer shell and whose lower cold end is connected to the cryocontainer (2) and into which a cold head (3) of a multistage cryocooler is installed, wherein the outer shell, the cryocontainer (2), the suspension tubes (16) and the neck tube (1) delimit an evacuated space,
wherein the cryocontainer (2) is moreover surrounded by at least one radiation shield which is connected to the suspension tubes (16) and optionally also to the neck tube (1) of the cryocontainer (2) in a thermally conducting fashion,
and wherein a seal which can be manually and/or automatically actuated is provided, by means of which the cold end of the neck tube (1) can be separated from the cryocontainer (2) in such a manner that fluid flow between the cryocontainer (2) and the neck tube (1) is minimized or completely interrupted.

2. Cryostat configuration according to claim 1, **characterized in that** the cryocontainer (2) contains a superconducting magnet configuration.

3. Cryostat configuration according to claim 2, **characterized in that** the superconducting magnet configuration is part of a nuclear magnetic resonance apparatus, in particular, for magnetic resonance imaging (MRI) or magnetic resonance spectroscopy (NMR).

4. Cryostat configuration according to any one of the claims 2 or 3, **characterized in that** a safety valve is disposed on at least one suspension tube (16), which opens in case the magnet quenches.

5. Cryostat configuration according to any one of the preceding claims, **characterized in that** the seal comprises a valve housing (4) which is detachably fixed to the lower end of the neck tube (1), and a rotatable valve plate (6) mounted thereto, which are both loaded by a spring (8).

6. Cryostat configuration according to claim 5, **characterized in that** the valve housing (4) and the valve plate (6) each have openings (5, 7) which can be moved into an aligned working position by turning the rotatable valve plate (6), and can be completely covered in a removal position by turning the rotatable valve plate (6).

7. Cryostat configuration according to any one of the preceding claims, **characterized in that** the cold head (3) of the cryocooler can freely rotate about its axis but can be fixed in its working position.

8. Cryostat configuration according to any one of the claims 5 to 6 or according to claim 7 provided that it refers to claim 5 or 6, **characterized in that** the rotatable valve plate (6) of the seal comprises at least two carrier elements (10).

9. Cryostat configuration according to claim 8, **characterized in that** an actuating element (9) is disposed on the lower end of the cold head (3) of the cryocooler, which engages in the carrier elements (10) on the rotatable valve plate (6) of the seal.

10. Cryostat configuration according to claim 9, **characterized in that** the cold head (3) of the cryocooler can be turned to a first stop (11) for opening the seal between the neck tube (1) and the cryocontainer (2).

11. Cryostat configuration according to claim 10, **characterized in that**, after rotation of the cold head (3) of the cryocooler to the first stop (11), the cold head (3) can be turned back through a defined angle into its working position in which the actuating element (9) and carrier elements (10) no longer contact each other.

12. Cryostat configuration according to any one of the claims 10 or 11, **characterized in that** the cold head (3) of the cryocooler can be turned to a second stop (12) opposite to the first stop (11) for closing the seal between the neck tube (1) and the cryocontainer (2).

13. Cryostat configuration according to claim 12, **characterized in that**, after rotation of the cold head (3) of the cryocooler to the second stop (12), the cold head can be turned back through a defined angle, wherein the actuating element (9) is in a central position between the carrier elements (10).

14. Cryostat configuration according to claim 13, **characterized in that** the cold head (3) of the cryocooler can be removed from the neck tube (1) exclusively in its position turned back through the defined angle (removal position), and is locked in all other positions.

15. Cryostat configuration according to any one of the claims 1 through 4, **characterized in that** a rotational element (18) is disposed below a suspension tube (16) of the cryocontainer (2) in extension of the axis (17) of the suspension tube (16) in the cryocontainer (2) and can be turned via an actuating rod (19) inserted through the suspension tube (16) when required.

16. Cryostat configuration according to claim 15, **characterized in that** a valve plate (6) is connected to the rotational element (18) below the suspension tube (16) via a pull rope (21).

17. Cryostat configuration according to claim 15, **characterized in that** a valve plate (6) is connected to the rotational element (18) below the suspension tube (16) via a chain.

18. Cryostat configuration according to claim 15, **characterized in that** a valve plate (6) is connected to the rotational element (18) below the suspension tube (16) via a pull rod and a push rod or via one single pull/push rod.

19. Cryostat configuration according to claim 4, **characterized in that** the seal comprises a counter plate (25) fixed to the lower end of the neck tube (1) and having an opening (35), as well as a valve cone (27) and a valve plate (22) which can be moved towards the neck tube (1) axis via a corrugated bellows (24) connected to the counter plate (25), the valve plate (22) having an opening cross-section which is considerably smaller than the cross-sectional area of the suspension tubes (16) and safety valves of the cryocontainer (2).

20. Cryostat configuration according to claim 19, **characterized in that** the valve cone (27) is horizontally fixed and is pretensioned and movable in a vertical direction by a spring (28).

21. Cryostat configuration according to any one of the claims 19 or 20, **characterized in that** the lift of the valve plate (22) towards the neck tube (1) axis is limited by at least one stop element (29).

22. Cryostat configuration according to any one of the claims 1 through 4, **characterized in that** the seal consists of one single fixed, but detachable plate (31) having an opening (30) of predetermined cross-section.

23. Cryostat configuration according to claim 22, **characterized in that** the cross-section of the opening (30) is considerably smaller than the cross-sectional areas of the suspension tubes (16) and safety valves of the cryocontainer (2).

24. Cryostat configuration according to any one of the claims 22 or 23, **characterized in that** the opening (30) in the plate (31) is disposed such that, in case of a quench, the gas flow enters the neck tube (1) in the direction of extension the neck tube.

25. Cryostat configuration according to any one of the claims 22 or 23, **characterized in that** the opening (30) in the plate (31) is designed in such a manner that, in case of a quench, the gas flow enters the neck tube (1) transversely to the neck tube direction.

26. Cryostat configuration according to any one of the preceding claims, **characterized in that** a seal which can be manually actuated can be arbitrarily combined with a seal which can be automatically actuated.

27. Cryostat configuration according to any one of the preceding claims, **characterized in that** the cryogenic fluid located in the cryocontainer (2) is helium.

## Revendications

1. Ensemble ou dispositif de cryostat avec une enveloppe extérieure et un récipient cryogénique (2) intégré dans celle-ci pour un fluide cryogénique,
le récipient cryogénique (2) étant relié à l'enveloppe extérieure par au moins deux tubes de suspension (16),
un tube à collet (1) étant prévu, dont l'extrémité supérieure chaude est reliée à l'enveloppe extérieure et l'extrémité inférieure froide au récipient cryogénique (2) et dans lequel une tête froide (3) d'un cryorefroidisseur à plusieurs étages est intégrée, l'enveloppe extérieure, le récipient cryogénique (2), les tubes de suspension (16) et le tube à collet (1) délimitant un espace mis sous vide,
le récipient cryogénique (2) étant en outre entouré par au moins un écran anti-rayonnement qui est relié de manière thermoconductrice aux tubes de suspension (16) et le cas échéant aussi au tube à collet (1) du récipient cryogénique (2),
et un obturateur à activation manuelle et/ou automatique étant prévu, au moyen duquel l'extrémité froide du tube à collet (1) peut être séparée du récipient cryogénique (2) de telle façon qu'un courant de fluide entre le récipient cryogénique (2) et le tube à collet (1) puisse être minimisé ou entièrement interrompu.

2. Ensemble cryostat selon la revendication 1, **caractérisé en ce que** le récipient cryogénique (2) contient un ensemble ou dispositif magnétique supraconducteur.

3. Ensemble cryostat selon la revendication 2, **caractérisé en ce que** l'ensemble magnétique supraconducteur fait partie d'un appareil de résonance magnétique nucléaire, en particulier d'imagerie par résonance magnétique (IRM) ou de spectroscopie par résonance magnétique (RMN).

4. Ensemble cryostat selon l'une des revendications 2 ou 3, **caractérisé en ce que** sur au moins un tube de suspension (16) est montée une soupape de sécurité qui s'ouvre en cas de quench magnétique.

5. Ensemble cryostat selon l'une des revendications précédentes, **caractérisé en ce que** l'obturateur comprend un boîtier de soupape (4) monté de manière fixe, mais détachable à l'extrémité inférieure du tube à collet (1) et une plaque de soupape rotative (6) montée dessus, lesquels sont mis sous tension par un ressort (8).

6. Ensemble cryostat selon la revendication 5, **caractérisé en ce que** le boîtier de soupape (4) et la plaque de soupape (6) présentent respectivement des ouvertures (5, 7) qui, par rotation de la plaque de soupape rotative (6) dans une position de travail, peuvent être mises en coïncidence ou recouvrement et, par rotation de la plaque de soupape rotative (6) dans une position de démontage, être complètement couvertes.

7. Ensemble cryostat selon l'une des revendications précédentes, **caractérisé en ce que** la tête froide (3) du cryorefroidisseur peut être tournée librement autour de son axe, mais être fixée dans sa position de travail.

8. Ensemble cryostat selon l'une des revendications 5 ou 6 ou selon la revendication 7 lorsque celle-ci se rattache à la revendication 5 ou 6, **caractérisé en ce que** la plaque de soupape rotative (6) de l'obturateur présente au moins deux éléments d'entraînement (10).

9. Ensemble cryostat selon la revendication 8, **caractérisé en ce qu'**à l'extrémité inférieure de la tête froide (3) du cryorefroidisseur est monté un élément d'actionnement (9) qui s'engage dans les éléments d'entraînement (10) sur la plaque de soupape rotative (6) de l'obturateur.

10. Ensemble cryostat selon la revendication 9, **caractérisé en ce que** pour ouvrir l'obturateur entre le tube à collet (1) et le récipient cryogénique (2), la tête froide (3) du cryorefroidisseur peut être tournée jusqu'à une première butée (11).

11. Ensemble cryostat selon la revendication 10, **caractérisé en ce qu'**après la rotation de la tête froide (3) du cryorefroidisseur jusqu'à la première butée (11), celle-ci peut être tournée en arrière d'un angle défini dans sa position de travail, dans laquelle l'élément d'actionnement (9) et les éléments d'entraînement (10) ne se touchent plus.

12. Ensemble cryostat selon l'une des revendications 10 ou 11, **caractérisé en ce que** pour fermer l'obturateur entre le tube à collet (1) et le récipient cryogénique (2), la tête froide (3) du cryorefroidisseur peut être tournée jusqu'à une deuxième butée (12) opposée à la première butée (11).

13. Ensemble cryostat selon la revendication 12, **caractérisé en ce qu'**après la rotation de la tête froide (3) du cryorefroidisseur jusqu'à la deuxième butée (12), celle-ci peut être tournée en arrière d'un angle défini dans une position dans laquelle l'élément d'actionnement (9) se trouve dans une position médiane entre les éléments d'entraînement (10).

14. Ensemble cryostat selon la revendication 13, **caractérisé en ce que** la tête froide (3) du cryorefroidisseur peut être retirée du tube à collet (1) uniquement dans la position tournée en arrière de l'angle défini (position de démontage) et est verrouillée dans toutes les autres positions.

15. Ensemble cryostat selon l'une des revendications 1 à 4, **caractérisé en ce que** sous un tube de suspension (16) du récipient cryogénique (2), en prolongement de l'axe (17) du tube de suspension (16) dans le récipient cryogénique (2), est disposé un élément rotatif (18), lequel peut être tourné par une tige d'actionnement (19) qui peut être insérée à travers le tube de suspension (16) en cas de besoin.

16. Ensemble cryostat selon la revendication 15, **caractérisé en ce qu'**une plaque de soupape (6) est reliée par un câble (21) à l'élément rotatif (18) sous le tube de suspension (16).

17. Ensemble cryostat selon la revendication 15, **caractérisé en ce qu'**une plaque de soupape (6) est reliée par une chaîne à l'élément rotatif (18) sous le tube de suspension (16).

18. Ensemble cryostat selon la revendication 15 **caractérisé en ce qu'**une plaque de soupape (6) est reliée par une tige de traction et une tige de pression ou une tige de traction/pression unique à l'élément rotatif (18) sous le tube de suspension (16).

19. Ensemble cryostat selon la revendication 4, **caractérisé en ce que** l'obturateur comprend une contre-plaque (25) montée de manière fixe à l'extrémité inférieure du tube à collet (1) et pourvue d'une ouverture (35) et d'un cône de soupape (27) ainsi qu'une plaque de soupape (22) mobile dans la direction de l'axe du tube à collet (1) au moyen d'un soufflet (24) relié à la contre-plaque (25), dont la section transversale d'ouverture est sensiblement plus petite que la surface de section transversale des tubes de suspension (16) et des soupapes de sécurité du récipient cryogénique (2).

20. Ensemble cryostat selon la revendication 19, **caractérisé en ce que** le cône de soupape (27) est fixé horizontalement et précontraint et mobile dans la direction verticale au moyen d'un ressort (28).

21. Ensemble cryostat selon l'une des revendications 19 ou 20, caractérisé en ce la levée de la plaque de soupape (22) dans la direction de l'axe du tube à collet (1) est limitée par au moins un élément de butée (29).

22. Ensemble cryostat selon l'une des revendications 1 à 4, **caractérisé en ce que** l'obturateur est constituée d'une seule plaque (31) montée de manière fixe mais détachable, qui est pourvue d'une ouverture (30) de section transversale prédéfinie.

23. Ensemble cryostat selon la revendication 22, **caractérisé en ce que** la section transversale de l'ouverture (30) est sensiblement plus petite que la surface de section transversale des tubes de suspension (16) et des soupapes de sécurité du récipient cryogénique (2).

24. Ensemble cryostat selon l'une des revendications 22 ou 23, **caractérisé en ce que** l'ouverture (30) dans la plaque (31) est réalisée de façon que, dans le cas d'un quench, le courant de gaz entre dans le tube à collet (1) dans la direction du tube à collet.

25. Ensemble cryostat selon l'une des revendications 22 ou 23, **caractérisé en ce que** l'ouverture (30) dans la plaque (31) est conçue ou réalisée de façon que, dans le cas d'un quench, le courant de gaz entre dans le tube à collet (1) transversalement à la direction du tube à collet.

26. Ensemble cryostat selon l'une des revendications précédentes, **caractérisé en ce qu'**un obturateur à activation manuelle peut être combiné à volonté avec un obturateur à activation automatique.

27. Ensemble cryostat selon l'une des revendications précédentes, caractérisé en ce le fluide cryogénique se trouvant dans le récipient cryogénique (2) est de l'hélium.
